# EUROPEAN PATENT SPECIFICATION

(11) **EP 3 731 410 B1**
(45) Date of publication and mention of the grant of the patent: **13.12.2023**
(21) Application number: 20180247.7
(22) Date of filing: 18.07.2017
(51) Int. Cl.: H03F 1/56, H03F 3/189, H03F 3/24, H03H 7/01, H01L 23/00

(54) **INTEGRATED PASSIVE DEVICE FOR RF POWER AMPLIFIER PACKAGE**
INTEGRIERTES PASSIVES BAUELEMENT FÜR VERSTÄRKERGEHÄUSE
COMPOSANT PASSIF INTÉGRÉ POUR MODULE D'AMPLIFICATEUR

(30) Priority: 21.07.2016 NL 2017206
(43) Date of publication of application: 28.10.2020
(62) Divisional of application: 17181815.6
(73) Proprietor: Ampleon Netherlands B.V., 6534 AV Nijmegen (NL)
(72) Inventor: De Boet, Johannes Adrianus Maria, 6534 AV Nijmegen (NL); Sveshtarov, Iordan Konstantinov, 6534 AV Nijmegen (NL); Van Rijs, Freerk, 6534 AV Nijmegen (NL)
(74) Representative: Arnold & Siedsma

(56) References cited:
- US-A1- 2002 014 923
- US-A1- 2007 188 259
- US-A1- 2012 154 054
- US-A1- 2013 033 325
- US-A1- 2015 381 121

## Description

The present invention relates to a radiofrequency (RF) power amplifier package. It further relates to a mobile telecommunications base station comprising such a RF power amplifier package, and to an integrated passive die suitable for such an RF power amplifier package.

RF power amplifier packages are known in the art. Such packages comprise a package and a semiconductor die, which die is arranged inside the package and is provided with an RF power transistor. The RF power transistor has an output capacitance and is configured to amplify signals at an operational frequency. Typically, an impedance network is arranged inside the package for providing impedance matching and/or filtering. These packages are typically used in base stations for the mobile communications market.

US2013/0033325 discloses an RF power transistor circuit including a power transistor and a decoupling circuit. The power transistor has a control electrode coupled to an input terminal for receiving an RF input signal, a first current electrode for providing an RF output signal at an output terminal, and a second current electrode coupled to a power supply voltage terminal. The decoupling circuit includes a first inductive element, a first resistor, and a first capacitor coupled together in series between the control electrode of the first power transistor and the power supply voltage terminal. The first decoupling circuit is for dampening a resonance at a frequency lower than an RF frequency.

US2015/0381121A1 discloses an integrated passive device (IPD) assembly including a first capacitor formed over a semiconductor substrate, where the first capacitor includes a first capacitor electrode, a second capacitor electrode, and dielectric material that electrically insulates the first capacitor electrode from the second capacitor electrode. The IPD assembly also includes a first contact pad exposed at a top surface of the IPD assembly and electrically coupled to the second capacitor electrode, and a second contact pad exposed at the top surface of the IPD. A second capacitor is coupled to the top surface of the IPD, and includes a first terminal electrically coupled to the first contact pad, and a second terminal electrically coupled to the second contact pad. The IPD assembly may be included in a packaged RF device, forming portions of an output impedance matching circuit and an envelope frequency termination circuit.

The evolution of the mobile communications market is essentially driven by a continuously increasing amount of data and transmission speed, resulting in a need for an increasingly larger instantaneous signal bandwidth. To linearly amplify wide band signals and minimize the memory effects it is necessary to terminate the second order intermodulation distortion (IMD) products occurring at relatively low frequencies with very low impedances. In case the impedance seen by RF power transistor at these frequencies is too high, the amplitude of the undesired signal components increases and the biasing of the transistor may be affected caused by feedback of the low-frequency IMD products into the biasing circuitry.

Another important aspect of RF power amplifiers is the ability to deliver the outputted signal at the desired power level. To that end, it is important that the RF power transistor is appropriately impedance matched. Ideally, the effective load seen by the RF power transistor should only have a small reactive part. In practice however, most RF power transistors have a considerable output capacitance. As an example, a typical laterally diffused metal-oxide-semiconductor (LDMOS) transistor, configured to provide output powers in the range of 150 Watts, has a drain-source capacitance of approximately 50 pF. In the frequency band of interest, which in the mobile base station market ranges from 600 MHz to 3.5 GHz and more, this capacitance strongly influences the impedance seen at the drain of the LDMOS.

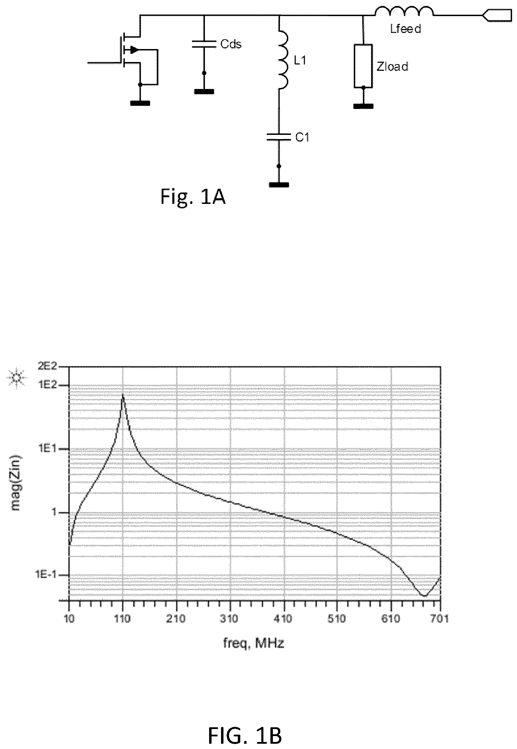

Figure 1A illustrates a known circuit topology that addresses the abovementioned influence of the output capacitance. This capacitance is denoted by Cds and is present between the drain (d) and source (s) of the FET. In figure 1A, a series resonance circuit formed by L1 and C1 is connected to the drain of the FET. Zload models the load that is presented to the FET and Lfeed models the feed inductance of the biasing circuit.

Due to its relatively large capacitance value, C1 is configured to act as a ground for signals at the RF operational frequency of the FET. L1 is chosen such that it will resonate with Cds at or close to the operational frequency. This allows the reactive part of the impedance seen by the FET to be sufficiently small at the operational frequency. However, at the same time C1 will resonate with the feed inductance Lfeed of the biasing circuitry at low frequencies. This will introduce a peak in the impedance seen at the drain of the FET as illustrated in figure 1B.

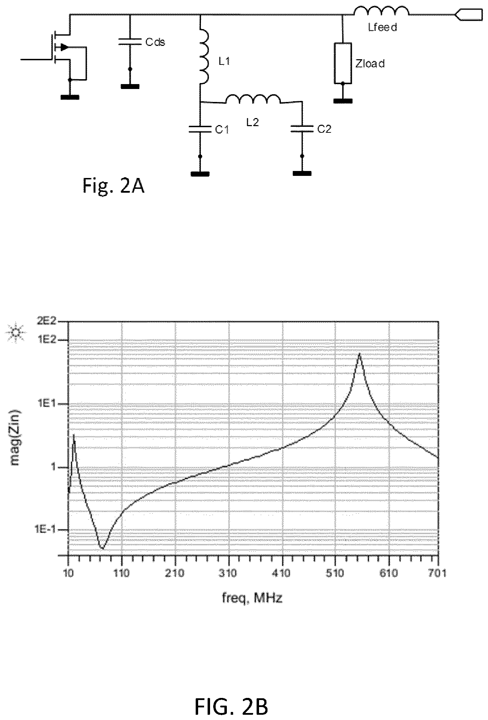

To mitigate this problem, a different topology has been introduced, which is illustrated in figure 2A. This topology differs from the topology in figure 1A in that a further inductance L2 and a further capacitance C2 have been included. C2 has a terminal electrically connected to L2 and another terminal electrically connected to ground.

Similar to figure 1A, C2 should be very large, and more in particular substantially larger than C1, and acts as a ground at RF and lower frequencies. For simplicity, the same component values for L1, Cds, and C1 are used in the topologies in figure 1A and 2A.

Similar to figure 1B, the circuit in figure 2A will show a first resonance occurring at a relatively low first resonance frequency related to the resonance between C2 and Lfeed, albeit at a lower frequency due to the influence of L2 and C1. However, a second resonance will occur at an intermediate second resonance frequency related to the resonance of L2 and C1. L2 and C1 form a parallel resonance circuit that will display a transition between a high positive and high negative reactive part near the resonance frequency of L2 and C 1. This reactive part will produce the second resonance shown in figure 2B.

As can be seen by comparing figures 1B and figure 2B, the first resonance frequency is shifted to lower frequencies. This, in combination with the second resonance frequency, allows a better control of the impedance at the frequencies that are associated with the second order modulation.

To further improve the abovementioned impedance behavior damping can be introduced. For example, a damping resistor can be placed in series with L2. This resistance will dampen the resonance at the first and second resonance frequencies. At the operational frequency, the combination of L2 and C1 will prevent that RF signals will be dissipated in the resistance, such that the impact of the resistance at the operational frequency will be minimal.

A practical implementation of C2 will display some energy losses. It is known that the quality factor of a parallel resonance circuit will generally decrease when its capacitance is increased. This will in turn reduce the peak height of the impedance at the first resonance frequency. Hence, to reduce the IMD products, it is preferred that C2 is as large as possible.

The first capacitance C1 also needs to be arranged inside the package. As this capacitance has a non-negligible influence on the RF behavior, it is important that the losses of this capacitor are also minimized.

The available space inside the package is limited. Consequently, increasing C2 results in less space being available for C1. This particularly holds when C1 and C2 are integrated on the same die. Typically, a highly doped substrate of the die forms one of the electrodes, which electrode is connected to the flange of the package that acts as ground. Hence, when C2 is increases, less space is available for grounding C1 which in turn will increases its losses. Therefore, in prior art approaches, a trade off has to be found between increasing control of the impedance at the second-order IMD frequencies and the overall efficiency of the power amplifier.

It is an object of the present invention to provide a circuit topology in which the abovementioned trade-off can be improved.

According to an aspect of the present invention, an RF power amplifier package as defined in any of the claims 1-13 is provided. According to another aspect of the present invention, an integrated passive die as defined in claim 14 is provided. According to yet another aspect of the present invention, a mobile telecommunications base station as defined in claim 15 is provided.

As the capacitance of the second capacitive element is much larger than the capacitance of the first capacitive element, the second capacitive element has larger electrodes. Furthermore, the second capacitive element acts as a ground at those frequencies for which the losses of the first capacitive element are relevant. By arranging the first capacitive element in series with the second capacitive element, the first capacitive element can use the relatively large electrode of the second capacitive element as an efficient ground connection, thereby avoiding the increased resistance observed in prior art approaches when the capacitance of the second capacitive element is increased at the expense of the grounding of the first capacitive element.

The first inductive element can be configured to resonate with the output capacitance at or close to the operational frequency. Furthermore, the RF power transistor can be configured to be fed using a feed inductance, wherein the second capacitive element can be configured to resonate with the feed inductance at a first resonance frequency that is substantially smaller than the operational frequency. The second inductive element can be configured to resonate with the first capacitive element at a second resonance frequency, wherein the first resonance frequency is substantially smaller than the second resonance frequency, and wherein the second resonance frequency is substantially smaller than the operational frequency.

The various resonance frequencies mentioned above may differ, to a small extent, to the resonance frequencies associated with the impedance seen at the output of the RF power transistor. For example, the impedance seen at the output of the RF power transistor may comprise a parallel contribution of the output capacitance, the impedance of impedance network, and the impedance associated with a matching network connected to the RF power transistor. A resonance in the overall impedance seen at the output of the RF power transistor can be achieved when the impedance of impedance network forms an open together with the other impedance contributions. As the impedance of the impedance network near a parallel resonance frequencies, varies strongly between a large positive value and a large negative value, such match can be found for a frequency close to the parallel resonance frequency.

The first and/or second inductive element may comprise an integrated inductor and/or a bondwire. An integrated inductor may comprise a spiral conductor and/or a transmission line realized on a substrate, such as a semiconductor die. This die may correspond to the die on which the RF power transistor is located. Alternatively, a separate die may be used on which at least one or all of the abovementioned inductive and capacitive elements are integrated.

The resonance circuit may comprise a resistive element for damping the first and second resonances. This resistive element is preferably arranged in series with the second inductive element or can be integrated therewith. By appropriately choosing the inductance and capacitance values it can be achieved that the RF performance at the operational frequency is not or hardly affected by this resistive element.

The second capacitive element is integrated on a second die, preferably a semiconductor die, wherein the second die is also arranged inside the package. The first capacitive element may be integrated on the second die. The package may comprise a flange and an output lead, wherein the first and/or second die is mounted to the flange, preferably using a die-bonding technique.

When the package is mounted in a final product, such as on a printed circuit board of a base station amplifier, the flange is connected to ground. By connecting the dies on the flange, a ground connection can be obtained. In some cases, the first and/second die may comprise a highly doped substrate allowing a low resistance path through the substrate. Alternatively, vias that extend through the substrate may be used to achieve a ground connection between the upper region of the dies and the bottom region that is connected, in a low-ohmic manner, to the flange.

Examples of integrated capacitors are interdigitated capacitors, fringe capacitors, deep trench capacitors, and metal-insulator-metal capacitors. The second capacitive element comprises a deep trench capacitor. The first capacitive element may comprise a metal-insulator-metal capacitor.

The first capacitive element may comprise a first and a second electrode having a first dielectric arranged there between. Furthermore, the second capacitive element may comprise a first and a second electrode having a second dielectric arranged there between, wherein the first electrode of the first capacitive element is electrically connected to the first inductive element and wherein the second electrode of the first capacitive element is electrically connected to the first electrode of the second capacitive element. Here, the second electrode of the second capacitive element can be electrically connected to ground. As the second capacitive element is substantially larger than the first capacitive element, in such a manner that at the operational frequency the second capacitive element acts as ground, the first capacitive element can use the relatively large first electrode of the second capacitive element as an efficient ground plane.

The first and second dies are elongated in a first direction, wherein the deep trench capacitor comprises a plurality of trenches extending in the second die, a second dielectric arranged inside the trenches, a top electrode arranged over the second dielectric, and a metal contact layer arranged on the top electrode, wherein the metal contact layer comprises a plurality of slots along the first direction. The second capacitive element may extend a first distance in the first direction, wherein the slots extend along a second distance in the first direction, wherein the second distance substantially equal to the first distance.

The applicant has found that, when using a second die, which is generally located in between the first die and the output lead of the package, return currents may flow through the relatively thin metal contact layer of the deep trench capacitor instead of the flange of the package or the semiconductor substrate. Such current may introduce losses that deteriorate RF performance. By arranging slots that extend in a direction perpendicular to the direction of the RF return current, the RF current can be forced to flow through the flange, which presents a much smaller resistance to the RF return current.

As described above, a resistive element can be used in the resonance unit to dampen the first and second resonances. This resistive element may be integrated on the second die, preferably in the form of a thin film resistor.

The first semiconductor die may comprise an output bondpad assembly, preferably bar-shaped, that is electrically connected to the output. Furthermore, the second die may comprise a first bondpad assembly that is electrically connected to the first capacitive element, and the RF power amplifier package may comprise a first plurality of bondwires that electrically connect the output bondpad assembly to the first bondpad assembly. In this case, the first plurality of bondwires substantially form the first inductive element, although the invention does not exclude that these bondwires cooperate with an integrated inductor, arranged on the first and/or second die, to form the first inductive element.

The RF power amplifier package may comprise a second plurality of bondwires that electrically connect the output bondpad assembly to the output lead. Here, the second plurality of bondwires forms a series inductance between the output of the RF power transistor and the output lead. This inductance may be part of an impedance matching network that is at least partially arranged inside the package. It may also be used as part of an impedance inverter for an integrated Doherty amplifier. In such case, the RF power amplifier package may comprise at least one other RF power transistor. The plurality of RF power transistors are biased differently, such that one transistor acts as a main amplifying stage and the other transistor(s) as a peak amplifying stage. Depending on the topology used, the second plurality of bondwires may be used to connect the main or peak amplifying stage to the output lead. It is noted that Doherty amplifiers, as well as integrated Doherty amplifiers that have at least part of the impedance inverters and/or signal combiners located inside the package, are known in the art.

The RF power amplifier package may further comprise a third inductive element and a third capacitive element arranged in series between the output lead and one of the flange, the second die, and/or the second capacitive element. This series combination can be used to perform in-package matching. The third capacitive element should in these cases, at least at the operational frequency, be effectively electrically connected to ground. The flange or the second capacitive element can be used for this purpose. Alternatively, if the second die comprises a highly doped substrate, an electrical connection between the second capacitive element and this substrate could be realized to achieve the ground connection.

The third capacitive element may be integrated on the second die, wherein the second die further comprises a second bondpad assembly electrically connected to a terminal of the third capacitive element. In this case, the RF power amplifier package may further comprise a third plurality of bondwires extending from the second bondpad assembly to the output lead. This third plurality of bondwires at least partially forms the third inductive element. Again, the bondwires may be combined with integrated inductors arranged on the second die. The other terminal of the third capacitive element can be electrically connected to one of the flange, the second die, and the second capacitive element.

Alternatively, the second die may comprise a second bondpad assembly, and an integrated third capacitive element having one terminal electrically connected to the second bondpad assembly and another terminal to one of the flange, the second die, and the second capacitive element. The RF power amplifier package may comprise a third plurality of bondwires electrically connecting the second bondpad assembly to the output lead. The RF power amplifier package may further comprise a second plurality of bondwires electrically connecting the second bondpad assembly and the output bondpad assembly.

The third inductive element and the third capacitive element may be configured for providing an impedance match at the operational frequency. The third capacitive element may comprise a deep trench or a metal-insulator-metal capacitor.

The package may further comprise a bias lead, and a fourth plurality of bondwires extending from the bias lead to the first bondpad assembly. This eliminates the need of Lfeed and provides significant space reduction on the external printed circuit board.

The first resonance frequency may lie in the range from 5 MHz to 20 MHz, the second resonance frequency in the range from 300 MHz to 650 MHz, and the operational frequency in the range from 800 MHz to 3.5 GHz and above.

The first semiconductor die may comprise a Silicon die or a suitable substrate, such as Silicon, Silicon Carbide, or Sapphire, having Gallium Nitride grown epitaxially thereon. The RF power transistor may comprise at least one of a laterally diffused metal-oxide-semiconductor transistor and a field-effect transistor.

Next, the invention will be described in more detail by referring to the appended drawings, wherein:
Figures 1A and 1B illustrate a known topology for improving the impedance match at the operational frequency;
Figures 2A and 2B illustrate a known improved topology for improving the impedance match at the operational frequency;
Figures 3A and 3B illustrate a general topology for improving the impedance match at the operational frequency in accordance with the present invention;
Figures 4A-4D show further topologies in accordance with the present invention;
Figure 5 illustrates an arrangement of the RF power amplifier package in accordance with the present invention; and
Figures 6A and 6B illustrate a comparison between an embodiment of a second die in which slots are not and are arranged, respectively.

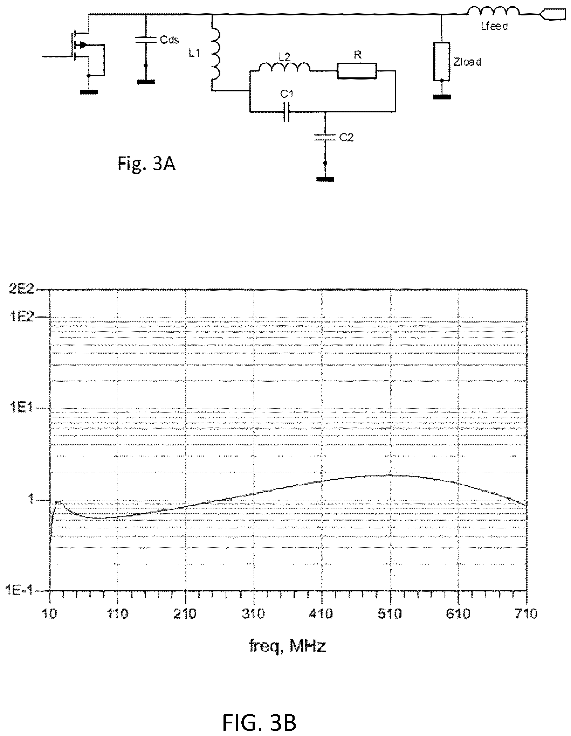

Figure 3A illustrates a general topology in accordance with the present invention. When comparing this topology with the topology in figure 2A, it can be seen that C1 is no longer directly connected to ground but is instead connected to C2. This latter capacitor, being substantially larger than C1, acts as a ground at the operational frequency of the RF power transistor. In addition, a resistive element R is arranged in series with L2.

Similar to the topology of figure 2A, a first resonance can be observed in the impedance seen looking away from the FET illustrated in figure 3B, which can be attributed to the parallel resonance of C2 and Lfeed. At this resonance frequency, the impedance of the series connection of L2 and R is substantially smaller than the impedance of C1. As such, the effective capacitance that is arranged in parallel to Lfeed will be roughly equal to C2. Moreover, the currents at this frequency will flow through R, causing the desired damping of the resonance peak in the impedance.

A second resonance peak can be observed in figure 3B, which can be attributed to the parallel resonance of C1 and L2, similar to the resonance in the topology of figure 2A. Also in this case, current will flow through R, causing the desired damping of the resonance peak in the impedance.

At the operational frequency L2 will substantially block the RF current, causing the larger part thereof to flow through C1 and C2. Consequently, the impact of the Ohmic losses in R is negligible at these frequencies. Moreover, at these frequencies the effective capacitance to ground of the resonance unit is substantially equal to C1 as C1 and C2 are arranged in series. L1 and C1 are chosen such that at or close the operational frequency, the resonance circuit acts as an inductance, having a value substantially equal to L1. This effective inductance, , will resonate with Cds to mitigate the impact of Cds at the operational frequency. At this frequency, the RF power transistor will ideally see only the desired impedance realized by the combination of the matching network, which is at least partially arranged outside the package, and the external load.

The description above provides a description of the functionality of the components Cds, L1, L2, R, C1, and C2. The skilled person readily understands that the values for these components strongly depend on, inter alia, the desired operational frequency, the size of the RF power transistor and the type of this transistor, the desired impedance behavior of the impedance at the second order IMD frequencies, and the desired bandwidth of the RF power amplifier made using the RF power amplifier package. The invention is therefore not limited to a particular range of values of these components.

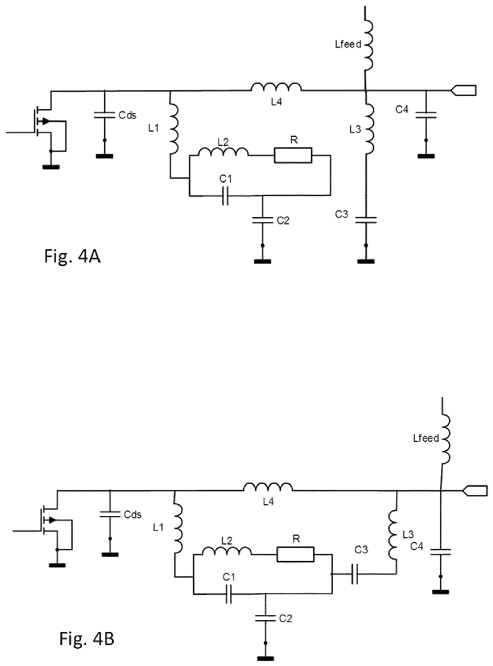

Figures 4A-4D show further topologies in accordance with the present invention. Here, an additional capacitor C4 can be identified that models the parasitic capacitance seen at the output lead of the package. Moreover, component C3 and L3 are added that perform an impedance matching inside the package at the operational frequency, for example to perform a downward impedance transformation for transforming the impedance at the output lead when looking at the external load to a lower value seen by the RF power transistor.

Figures 4A-4D differ in the way how C3 and L3 are connected. Depending on the desired functionality of L3, different implementations can be identified. For example, if L3 is intended solely for impedance matching, the following matching stages can be identified at the operational frequency:
For the figure 4A and 4B topology, a first stage comprising a series inductance L4 and a shunt capacitance equal to C3, assuming that C4 is much smaller than C3 and assuming that C3 is much smaller than C2;

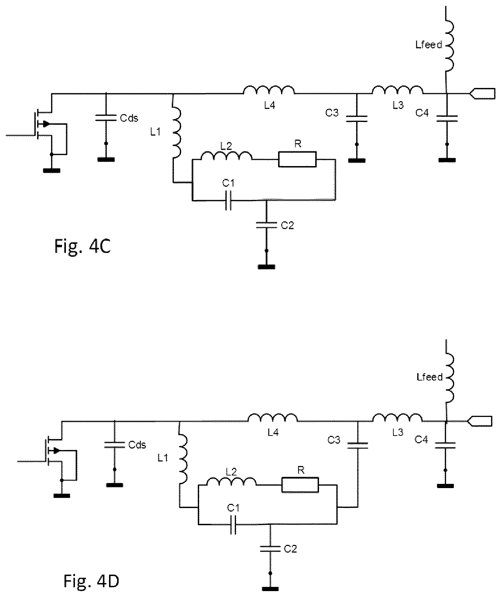

For the figure 4C and 4D topology, a first stage comprising a series inductance L3 and a shunt capacitance equal to C3, and a second stage comprising a series inductance L4 and a shunt capacitor equal to C4.

Alternatively, L3 can be intended as part of an impedance inverter, for instance when the RF power amplifier package is to be used in a Doherty amplifier, wherein the RF power amplifier package comprises a RF power transistor acting as a main amplifying stage and a RF power transistor acting as a peak amplifying stage. Referring to figure 4A for example, an equivalent PI-network can be formed by the resonance network, Cds, L3, C3, L4. Ideally, these components should perform a 90 degrees phase shift, or multiples thereof, at the operational frequency. It may be advantageous in such applications to design the resonance unit such that at the operational frequency a residual capacitance exists to form the first shunt capacitor of the PI-network for the impedance inverter.

In figures 4A and 4C, C3 is grounded directly. In practical implementations, C3 may be realized as a discrete capacitor that is mounted to the flange separately from the first and second dies. Alternatively, C3 may be integrated on the first or second die. In this latter case, C3 can be connected to the conducting substrate, which in turn is connected to the flange. When C3 is integrated in the second die, it can be connected to C2, as illustrated in figures 4B and 4D.

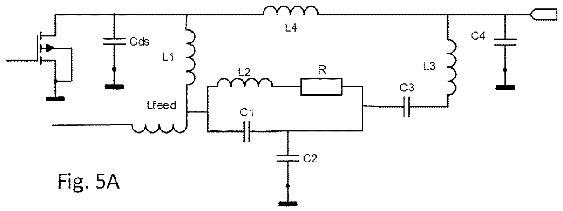

Figure 5A illustrates an embodiment according to the invention, wherein the feed line, modeled by Lfeed, is integrated in the package and connected to the second die, and more in particular to the first capacitor. The advantage is substantial reduction of the total size of the power amplifier and ease of use of the RF power transistor.

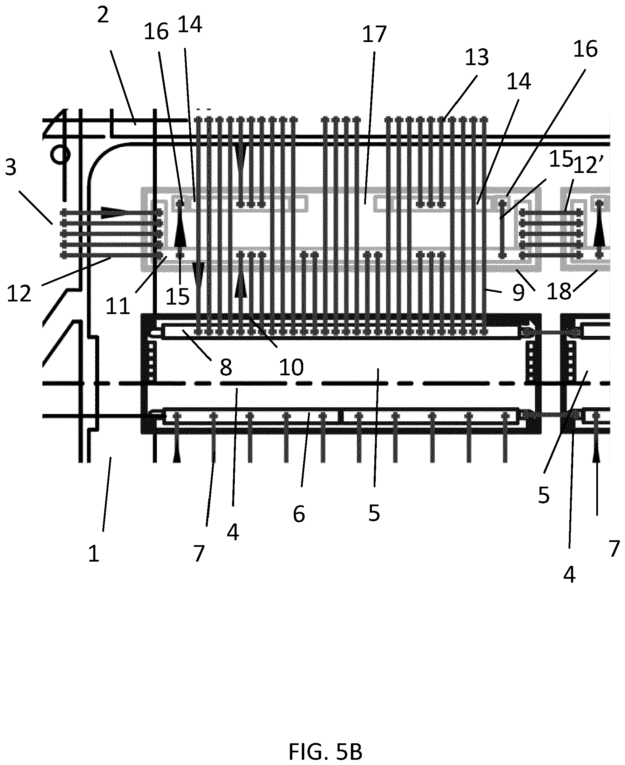

Figure 5B illustrates a practical implementation of the embodiment of figure 5A. This figure shows a package comprising a flange 1, an output lead 2, and a bias lead 3. A pair of semiconductor dies 4 is mounted on flange 1. On these dies, RF power transistors 5 are arranged, which are only schematically illustrated. In this example, RF power transistors 5 are formed as LDMOS transistors arranged on a highly doped substrate.

The gate input of the transistors 5 is connected to a bar-shaped bondpad assembly 6. A plurality of bondwires 7 is used to connect to the gates of transistors 5.

The drain outputs of transistors 5 is connected to a bar-shaped bondpad assembly 8. A plurality of bondwires 9, forming L4, connects the drain outputs to output lead 2. A second plurality of bondwires 10, forming L1, connects the drain outputs to a U-shaped bondpad assembly 11 that is arranged on a second die 18. This assembly is electrically connected to the common point of L2 and C1. A further plurality of bondwires 12, partially forming Lfeed, connects bias lead 3 to bondpad assembly 11. Bondwires 12' relay the bias to the other RF power transistor 5.

Bondwires 13, forming L3, connect output lead 2 to a bar-shaped bondpad assembly 14 that is electrically connected to a terminal of C3. The other terminal of C3 is connected to the top electrode of C2 (not illustrated). Bondwires 15, forming L2, connect bondpad assembly 11 to a bondpad 16 that is electrically connected to a thin film resistor R that is located at a buried position 17.

Die 18 comprises a highly doped Silicon substrate on which C2 is distributed as a deep trench capacitor. The top electrode of C2 is connected to the bottom electrode of C1. The other electrode of C2 is formed by the highly doped substrate. The top electrode of C1 is connected to bondpad assembly 11.

The embodiment in figure 5B illustrates two separate dies 4, 18 on which the various components are realized. The present invention does not exclude embodiments wherein only a single die is used on which both the active and passive components are integrated.

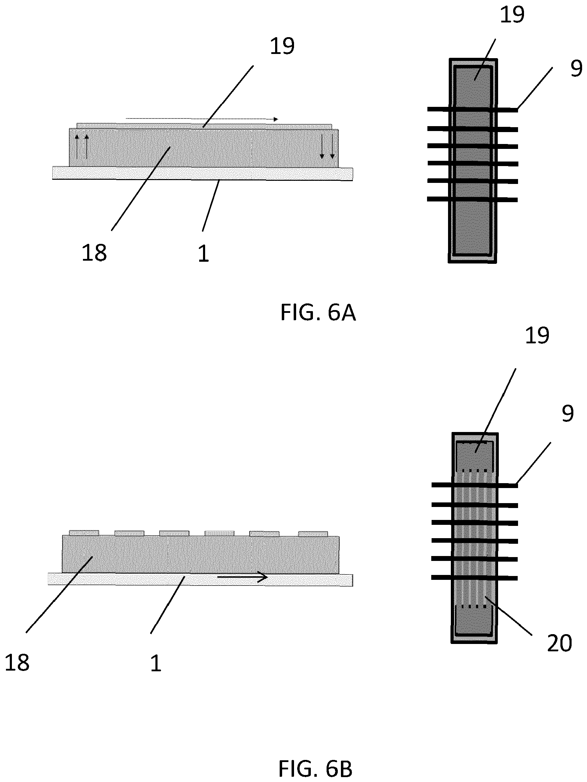

As can be seen in figure 5B, bondwires 9 carry the output current to output lead 2 across die 18. A return current is associated with this current. This current is schematically illustrated in figure 6A. This figure illustrates flange 1 on which die 18 is arranged. This figure also shown the top electrode of C2, which in this example is formed as a 1 micrometer thick metal layer19. The resistance associate with layer 19 is much higher than the resistance associated with flange 1. Consequently, unwanted losses will be introduced at the operational frequency. The embodiment shown in figure 6B addresses this problem.

To direct the return current, slots 20 can be arranged in metal layer 19 that extend perpendicular to the flow of the return current in figure 6A. Generally, C2 will be distributed over the entire die 18, thereby having an elongated structure extending in a first direction. Slots 20 are preferably arranged along this first direction and preferably extend over substantially the entire length of metal layer 19. Using slots 20, the return current is forced to flow through flange 1, thereby reducing the losses at the operational frequency.

Although the present invention has been described using detailed embodiments thereof, the skilled person would readily understand that the present invention is not limited thereto, but that various modifications can be made to these embodiments without departing from the scope of the invention which is defined by the appended claims.

## Claims

1. A radiofrequency, `RF', power amplifier package, comprising:
a package;
a first semiconductor die (4) arranged inside said package and provided with an RF power transistor, said RF power transistor having an output capacitance (Cds) and being configured to amplify signals at an operational frequency;
an impedance network arranged inside the package and comprising:
a first inductive element (L1) having a first and second terminal, the first terminal being electrically connected to an output of the RF transistor;
a resonance unit being electrically connected to the second terminal of the first inductive element;
a second capacitive element (C2) electrically connected in between the resonance unit and ground;
wherein the resonance unit comprises a second inductive element (L2) electrically connected in between the second capacitive element and the first inductive element, and a first capacitive element (C1) having a first and second terminal, the first terminal of the first capacitive element being electrically connected to the second terminal of the first inductive element;
wherein the capacitance of the second capacitive element is larger than the capacitance of the first capacitive element;
wherein the second terminal of the first capacitive element is electrically connected to the second capacitive element;
**characterized in that** the second capacitive element is integrated on a second die (18), preferably a semiconductor die, said second die being arranged inside the package, wherein the second capacitive element comprises a deep trench capacitor;
**and in that** the first semiconductor die and the second die are elongated in a first direction, wherein the deep trench capacitor comprises a plurality of trenches extending in the second die, a second dielectric arranged inside the trenches, a top electrode arranged over the second dielectric, and a metal contact layer (19) arranged on the top electrode, wherein the metal contact layer comprises a plurality of slots (20) along the first direction.

2. The RF power amplifier package according to claim 1, wherein the package comprises a flange (1) and an output lead (2), wherein the first semiconductor die and second die are mounted to the flange, preferably using a die-bonding technique, wherein the first semiconductor die comprises an output bondpad assembly (8), wherein the RF power amplifier package comprises a second plurality of bondwires (9) electrically connecting the output bondpad assembly to the output lead, wherein the second plurality of bondwires extends over the second die.

3. The RF power amplifier package according to claim 1 or 2, wherein the second die comprises a first bondpad assembly (11) electrically connected to the first capacitive element, wherein the RF power amplifier package comprises a first plurality of bondwires (10) that electrically connect the output bondpad assembly to the first bondpad assembly, said first plurality of bondwires substantially forming the first inductive element.

4. The RF power amplifier package according to any of the previous claims, wherein the second capacitive element extends a first distance in the first direction, and wherein the slots extend along a second distance in the first direction, wherein the second distance is substantially equal to the first distance.

5. The RF power amplifier package according to any of the previous claims, wherein the first capacitive element is integrated on the second die.

6. The RF power amplifier package according to any of the previous claims, wherein the first capacitive element comprises a metal-insulator-metal capacitor.

7. The RF power amplifier package according to any of the previous claims, wherein the first inductive element is configured to resonate with the output capacitance at or close to the operational frequency; and/or
wherein the RF power transistor is configured to be fed using a feed inductance (Lfeed), and wherein the second capacitive element is configured to resonate with the feed inductance at a first resonance frequency that is substantially smaller than the operational frequency; and/or
wherein the second inductive element is configured to resonate with the first capacitive element at a second resonance frequency, wherein the first resonance frequency is substantially smaller than the second resonance frequency and wherein the second resonance frequency is substantially smaller than the operational frequency.

8. The RF power amplifier package according to any of the previous claims, wherein the first and/or second inductive element comprises an integrated inductor and/or a bondwire; and/or
wherein the resonance circuit comprises a resistive element (R) for damping the first and second resonances, wherein the resistive element is preferably arranged in series with the second inductive element or is integrated therewith.

9. The RF power amplifier package according to claim 8, wherein the resistive element is integrated on the second die, preferably in the form of a thin film resistor.

10. The RF power amplifier package according to any of the previous claims, further comprising a third inductive element (L3) and a third capacitive element (C3) arranged in series between the output lead and one of the flange, the second die, and/or the second capacitive element;
wherein preferably:
the third capacitive element is integrated on the second die, said second die further comprising a second bondpad assembly (14) electrically connected to a terminal of the third capacitive element, the RF power amplifier package further comprising a third plurality of bondwires (13) extending from the second bondpad assembly to the output lead, said third plurality of bondwires substantially forming the third inductive element, the third capacitive element having another terminal electrically connected to one of the flange, the second die, and the second capacitive element; and/or
the third inductive element and the third capacitive element are configured for providing an impedance match at the operational frequency; and/or
the third capacitive element comprises a deep trench capacitor or a metal-insulator-metal capacitor.

11. The RF power amplifier package according to claim 2, wherein the second die comprises a second bondpad assembly (14), and an integrated third capacitive element (C3) having one terminal electrically connected to the second bondpad assembly and another terminal to one of the flange, the second die, and the second capacitive element, wherein the RF power amplifier package comprises a third plurality of bondwires electrically (13) connecting the second bondpad assembly to the output lead, the RF power amplifier package further comprising a second plurality of bondwires electrically connecting the second bondpad assembly and the output bondpad assembly.

12. The RF power amplifier package according to any of the previous claims, wherein the package comprises a bias lead (3), and a fourth plurality of bondwires (12) extending from the bias to the first capacitive element.

13. The RF power amplifier package according to any of the previous claims, wherein the first resonance frequency lies in the range from 5 to 20 MHz, the second resonance frequency lies in the range from 300 to 650 MHz, and the operational frequency lies in the range from 800 MHz to 3.5GHz and above, and/or wherein the first semiconductor die comprises a Silicon die or a Gallium Nitride die, and/or wherein the RF power transistor comprises at least one of a laterally diffused metal-oxide-semiconductor transistor and a field-effect transistor.

14. An integrated passive die suitable for an RF power amplifier package as defined in any of the previous claims, wherein the integrated passive die comprises the second die as defined in any of the previous claims.

15. A mobile telecommunications base station comprising the RF power amplifier package as defined in any of the claims 1-13

## Patentansprüche

1. Hochfrequenz- (HF) -Leistungsverstärkergehäuse, das Folgendes umfasst:
ein Gehäuse;
einen ersten Halbleiterchip (4), der innerhalb des Gehäuses angeordnet und mit einem HF-Leistungstransistor versehen ist, wobei der HF-Leistungstransistor eine Ausgangskapazität (Cds) aufweist und zum Verstärken von Signalen bei einer Betriebsfrequenz ausgelegt ist;
ein Impedanznetzwerk, das innerhalb des Gehäuses angeordnet ist und Folgendes umfasst:
ein erstes induktives Element (L1) mit einem ersten und einem zweiten Anschluss, wobei der erste Anschluss elektrisch mit einem Ausgang des HF-Transistors verbunden ist;
eine Resonanzeinheit, die elektrisch mit dem zweiten Anschluss des ersten induktiven Elements verbunden ist;
ein zweites kapazitives Element (C2), das elektrisch zwischen der Resonanzeinheit und Masse angeschlossen ist;
wobei die Resonanzeinheit ein zweites induktives Element (L2) umfasst, das elektrisch zwischen dem zweiten kapazitiven Element und dem ersten induktiven Element angeschlossen ist, und ein erstes kapazitives Element (C1) mit einem ersten und einem zweiten Anschluss, wobei der erste Anschluss des ersten kapazitiven Elements elektrisch mit dem zweiten Anschluss des ersten induktiven Elements verbunden ist;
wobei die Kapazität des zweiten kapazitiven Elements größer ist als die Kapazität des ersten kapazitiven Elements;
wobei der zweite Anschluss des ersten kapazitiven Elements elektrisch mit dem zweiten kapazitiven Element verbunden ist;
**dadurch gekennzeichnet, dass** das zweite kapazitive Element auf einem zweiten Chip (18), vorzugsweise einem Halbleiterchip, integriert ist, wobei der zweite Chip innerhalb des Gehäuses angeordnet ist, wobei das zweite kapazitive Element einen Deep-Trench-Kondensator umfasst;
**und dass** der erste Halbleiterchip und der zweite Chip in einer ersten Richtung langgestreckt sind, wobei der Deep-Trench-Kondensator Folgendes umfasst: eine Vielzahl von Gräben, die sich in dem zweiten Chip erstrecken, ein zweites Dielektrikum, das innerhalb der Gräben angeordnet ist, eine obere Elektrode, die über dem zweiten Dielektrikum angeordnet ist, und eine Metallkontaktschicht (19), die auf der oberen Elektrode angeordnet ist, wobei die Metallkontaktschicht eine Vielzahl von Schlitzen (20) entlang der ersten Richtung umfasst.

2. HF-Leistungsverstärkergehäuse nach Anspruch 1, wobei das Gehäuse einen Flansch (1) und eine Ausgangsleitung (2) umfasst, wobei der erste Halbleiterchip und der zweite Chip an dem Flansch montiert sind, vorzugsweise unter Verwendung einer eines Chip-Bondverfahrens, wobei der erste Halbleiterchip eine Ausgangs-Bondpad-Anordnung (8) umfasst, wobei das HF-Leistungsverstärkergehäuse eine zweite Vielzahl von Bonddrähten (9) umfasst, die die Ausgangs-Bondpad-Anordnung elektrisch mit der Ausgangsleitung verbinden, wobei sich die zweite Vielzahl von Bonddrähten über den zweiten Chip erstreckt.

3. HF-Leistungsverstärkergehäuse nach Anspruch 1 oder 2, wobei der zweite Chip eine erste Bondpad-Anordnung (11) umfasst, die elektrisch mit dem ersten kapazitiven Element verbunden ist, wobei das HF-Leistungsverstärkergehäuse eine erste Vielzahl von Bonddrähten (10) umfasst, die die Ausgangs-Bondpad-Anordnung elektrisch mit der ersten Bondpad-Anordnung verbinden, wobei die erste Vielzahl von Bonddrähten im Wesentlichen das erste induktive Element bildet.

4. HF-Leistungsverstärkergehäuse nach einem der vorhergehenden Ansprüche, wobei sich das zweite kapazitive Element über eine erste Distanz in die erste Richtung erstreckt, und wobei sich die Schlitze entlang einer zweiten Distanz in der ersten Richtung erstrecken, wobei die zweite Distanz im Wesentlichen gleich der ersten Distanz ist.

5. HF-Leistungsverstärkergehäuse nach einem der vorhergehenden Ansprüche, wobei das erste kapazitive Element auf dem zweiten Chip integriert ist.

6. HF-Leistungsverstärkergehäuse nach einem der vorhergehenden Ansprüche, wobei das erste kapazitive Element einen Metall-Isolator-Metall-Kondensator umfasst.

7. HF-Leistungsverstärkergehäuse nach einem der vorhergehenden Ansprüche, wobei das erste induktive Element so ausgelegt ist, dass es mit der Ausgangskapazität bei oder nahe der Betriebsfrequenz in Resonanz kommt; und/oder
wobei der HF-Leistungstransistor so ausgelegt ist, dass er über eine Speiseinduktivität (Lfeed) gespeist wird, und wobei das zweite kapazitive Element so ausgelegt ist, dass es mit der Speiseinduktivität bei einer ersten Resonanzfrequenz in Resonanz kommt, die wesentlich kleiner als die Betriebsfrequenz ist; und/oder
wobei das zweite induktive Element so ausgelegt ist, dass es mit dem ersten kapazitiven Element bei einer zweiten Resonanzfrequenz in Resonanz kommt, wobei die erste Resonanzfrequenz wesentlich kleiner als die zweite Resonanzfrequenz ist und wobei die zweite Resonanzfrequenz wesentlich kleiner als die Betriebsfrequenz ist.

8. HF-Leistungsverstärkergehäuse nach einem der vorhergehenden Ansprüche, wobei das erste und/oder zweite induktive Element einen integrierten Induktor und/oder einen Bonddraht umfasst; und/oder
wobei der Resonanzkreis ein Widerstandselement (R) zum Dämpfen der ersten und zweiten Resonanzen umfasst, wobei das Widerstandselement vorzugsweise in Reihe mit dem zweiten induktiven Element angeordnet oder mit diesem integriert ist.

9. HF-Leistungsverstärkergehäuse nach Anspruch 8, wobei das Widerstandselement auf dem zweiten Chip integriert ist, vorzugsweise in Form eines Dünnschichtwiderstands.

10. HF-Leistungsverstärkergehäuse nach einem der vorhergehenden Ansprüche, ferner umfassend ein drittes induktives Element (L3) und ein drittes kapazitives Element (C3), die in Reihe zwischen der Ausgangsleitung und entweder dem Flansch, dem zweiten Chip und/oder dem zweiten kapazitiven Element angeordnet sind;
wobei vorzugsweise:
das dritte kapazitive Element auf dem zweiten Chip integriert ist, wobei der zweite Chip ferner eine zweite Bondpad-Anordnung (14) umfasst, die elektrisch mit einem Anschluss des dritten kapazitiven Elements verbunden ist, wobei das HF-Leistungsverstärkergehäuse ferner eine dritte Vielzahl von Bonddrähten (13) umfasst, die sich von der zweiten Bondpad-Anordnung zu der Ausgangsleitung erstrecken, wobei die dritte Vielzahl von Bonddrähten im Wesentlichen das dritte induktive Element bildet, wobei das dritte kapazitive Element einen weiteren Anschluss aufweist, der entweder mit dem Flansch, dem zweiten Chip oder dem zweiten kapazitiven Element elektrisch verbunden ist; und/oder
das dritte induktive Element und das dritte kapazitive Element für die Bereitstellung einer Impedanzanpassung bei der Betriebsfrequenz ausgelegt sind; und/oder
das dritte kapazitive Element einen Deep-Trench-Kondensator oder einen Metall-Isolator-Metall-Kondensator umfasst.

11. HF-Leistungsverstärkergehäuse nach Anspruch 2, wobei der zweite Chip eine zweite Bondpad-Anordnung (14) und ein integriertes drittes kapazitives Element (C3) umfasst, dessen einer Anschluss elektrisch mit der zweiten Bondpad-Anordnung verbunden ist und dessen anderer Anschluss entweder mit dem Flansch, dem zweiten Chip oder dem zweiten kapazitiven Element verbunden ist, wobei das HF-Leistungsverstärkergehäuse eine dritte Vielzahl von Bonddrähten (13) umfasst, die die zweite Bondpad-Anordnung elektrisch mit der Ausgangsleitung verbinden, wobei das HF-Leistungsverstärkergehäuse ferner eine zweite Vielzahl von Bonddrähten umfasst, die die zweite Bondpad-Anordnung und die Ausgangs-Bondpad-Anordnung elektrisch verbinden.

12. HF-Leistungsverstärkergehäuse nach einem der vorhergehenden Ansprüche, wobei das Gehäuse einen Vorspannungsleiter (3) und eine vierte Vielzahl von Bonddrähten (12) umfasst, die sich von der Vorspannung zu dem ersten kapazitiven Element erstrecken.

13. HF-Leistungsverstärkergehäuse nach einem der vorhergehenden Ansprüche, wobei die erste Resonanzfrequenz im Bereich von 5 bis 20 MHz liegt, die zweite Resonanzfrequenz im Bereich von 300 bis 650 MHz liegt und die Betriebsfrequenz im Bereich von 800 MHz bis 3,5 GHz und darüber liegt, und/oder wobei der erste Halbleiterchip einen Siliziumchip oder einen Galliumnitridchip umfasst und/oder wobei der HF-Leistungstransistor mindestens einen von einem lateral diffundierten Metalloxid-Halbleitertransistor und einem Feldeffekttransistor umfasst.

14. Integrierter passiver Chip, der für ein HF-Leistungsverstärkergehäuse nach einem der vorhergehenden Ansprüche geeignet ist, wobei der integrierte passive Chip den zweiten Chip nach einem der vorhergehenden Ansprüche umfasst.

15. Mobiltelekommunikations-Basisstation, die das HF-Leistungsverstärkergehäuse nach einem der Ansprüche 1 bis 13 umfasst.

## Revendications

1. Boîtier d'amplificateur de puissance radiofréquence, « RF », comprenant :
un boîtier ;
une première puce à semi-conducteurs (4) agencée à l'intérieur dudit boîtier et munie d'un transistor de puissance RF, ledit transistor de puissance RF ayant une capacité de sortie (Cds) et étant configuré pour amplifier des signaux à une fréquence opérationnelle ;
un réseau d'impédance agencé à l'intérieur du boîtier et comprenant :
un premier élément inductif (L1) ayant une première et une deuxième borne, la première borne étant électriquement connectée à une sortie du transistor RF ;
une unité de résonance qui est électriquement connectée à la deuxième borne du premier élément inductif ;
un deuxième élément capacitif (C2) électriquement connecté entre l'unité de résonance et la masse ;
dans lequel l'unité de résonance comprend un deuxième élément inductif (L2) électriquement connecté entre le deuxième élément capacitif et le premier élément inductif, et un premier élément capacitif (C1) ayant une première et une deuxième borne, la première borne du premier élément capacitif étant électriquement connectée à la deuxième borne du premier élément inductif ;
dans lequel la capacité du deuxième élément capacitif est plus grande que la capacité du premier élément capacitif ;
dans lequel la deuxième borne du premier élément capacitif est électriquement connectée au deuxième élément capacitif ;
**caractérisé en ce que** le deuxième élément capacitif est intégré sur une deuxième puce (18), de préférence une puce à semi-conducteurs, ladite deuxième puce étant agencée à l'intérieur du boîtier, dans lequel le deuxième élément capacitif comprend un condensateur à tranchées profondes ;
et **en ce que** la première puce à semi-conducteurs et la deuxième puce sont allongées dans une première direction, dans lequel le condensateur à tranchées profondes comprend une pluralité de tranchées s'étendant dans la deuxième puce, un deuxième diélectrique agencé à l'intérieur des tranchées, une électrode supérieure agencée par-dessus le deuxième diélectrique, et une couche de contact métallique (19) agencée sur l'électrode supérieure, dans lequel la couche de contact métallique comprend une pluralité de fentes (20) le long de la première direction.

2. Boîtier d'amplificateur de puissance RF selon la revendication 1, dans lequel le boîtier comprend une semelle (1) et un conducteur de sortie (2), dans lequel la première puce à semi-conducteurs et la deuxième puce sont montées sur la semelle, de préférence à l'aide d'une technique de liaison de puce, dans lequel la première puce à semi-conducteurs comprend un ensemble plot de liaison de sortie (8), dans lequel le boîtier d'amplificateur de puissance RF comprend une deuxième pluralité de fils de liaison (9) connectant électriquement l'ensemble plot de liaison de sortie au conducteur de sortie, dans lequel la deuxième pluralité de fils de liaison s'étend par-dessus la deuxième puce.

3. Boîtier d'amplificateur de puissance RF selon la revendication 1 ou 2, dans lequel la deuxième puce comprend un premier ensemble plot de liaison (11) électriquement connecté au premier élément capacitif, dans lequel le boîtier d'amplificateur de puissance RF comprend une première pluralité de fils de liaison (10) qui connectent électriquement l'ensemble plot de liaison de sortie au premier ensemble plot de liaison, ladite première pluralité de fils de liaison formant sensiblement le premier élément inductif.

4. Boîtier d'amplificateur de puissance RF selon l'une quelconque des revendications précédentes, dans lequel le deuxième élément capacitif s'étend sur une première distance dans la première direction, et dans lequel les fentes s'étendent le long d'une deuxième distance dans la première direction, dans lequel la deuxième distance est sensiblement égale à la première distance.

5. Boîtier d'amplificateur de puissance RF selon l'une quelconque des revendications précédentes, dans lequel le premier élément capacitif est intégré sur la deuxième puce.

6. Boîtier d'amplificateur de puissance RF selon l'une quelconque des revendications précédentes, dans lequel le premier élément capacitif comprend un condensateur métal-isolant-métal.

7. Boîtier d'amplificateur de puissance RF selon l'une quelconque des revendications précédentes, dans lequel le premier élément inductif est configuré pour résonner avec la capacité de sortie à la fréquence opérationnelle ou aux environs de celle-ci ; et/ou
dans lequel le transistor de puissance RF est configuré pour être alimenté à l'aide d'une inductance d'alimentation (Lfeed), et dans lequel le deuxième élément capacitif est configuré pour résonner avec l'inductance d'alimentation à une première fréquence de résonance qui est sensiblement plus petite que la fréquence opérationnelle ; et/ou
dans lequel le deuxième élément inductif est configuré pour résonner avec le premier élément capacitif à une deuxième fréquence de résonance, dans lequel la première fréquence de résonance est sensiblement plus petite que la deuxième fréquence de résonance et dans lequel la deuxième fréquence de résonance est sensiblement plus petite que la fréquence opérationnelle.

8. Boîtier d'amplificateur de puissance RF selon l'une quelconque des revendications précédentes, dans lequel le premier et/ou deuxième élément inductif comprend un inducteur intégré et/ou un fil de liaison ; et/ou
dans lequel le circuit de résonance comprend un élément résistif (R) pour l'amortissement des première et deuxième résonances, dans lequel l'élément résistif est de préférence agencé en série avec le deuxième élément inductif ou est intégré à celui-ci.

9. Boîtier d'amplificateur de puissance RF selon la revendication 8, dans lequel l'élément résistif est intégré sur la deuxième puce, de préférence sous la forme d'une résistance en couches minces.

10. Boîtier d'amplificateur de puissance RF selon l'une quelconque des revendications précédentes, comprenant en outre un troisième élément inductif (L3) et un troisième élément capacitif (C3) agencés en série entre le conducteur de sortie et l'un parmi la semelle, la deuxième puce et/ou le deuxième élément capacitif ;
dans lequel de préférence :
le troisième élément capacitif est intégré sur la deuxième puce, ladite deuxième puce comprenant en outre un deuxième ensemble plot de liaison (14) électriquement connecté à une borne du troisième élément capacitif, le boîtier d'amplificateur de puissance RF comprenant en outre une troisième pluralité de fils de liaison (13) s'étendant du deuxième ensemble plot de liaison au conducteur de sortie, ladite troisième pluralité de fils de liaison formant sensiblement le troisième élément inductif, le troisième élément capacitif ayant une autre borne électriquement connectée à l'un parmi la semelle, la deuxième puce et le deuxième élément capacitif ; et/ou
le troisième élément inductif et le troisième élément capacitif sont configurés pour la fourniture d'une adaptation d'impédance à la fréquence opérationnelle ; et/ou
le troisième élément capacitif comprend un condensateur à tranchées profondes ou un condensateur métal-isolant-métal.

11. Boîtier d'amplificateur de puissance RF selon la revendication 2, dans lequel la deuxième puce comprend un deuxième ensemble plot de liaison (14), et un troisième élément capacitif (C3) intégré ayant une borne électriquement connectée au deuxième ensemble plot de liaison et une autre borne à l'un parmi la semelle, la deuxième puce et le deuxième élément capacitif, dans lequel le boîtier d'amplificateur de puissance RF comprend une troisième pluralité de fils de liaison connectant électriquement (13) le deuxième ensemble plot de liaison au conducteur de sortie, le boîtier d'amplificateur de puissance RF comprenant en outre une deuxième pluralité de fils de liaison connectant électriquement le deuxième ensemble plot de liaison et l'ensemble plot de liaison de sortie.

12. Boîtier d'amplificateur de puissance RF selon l'une quelconque des revendications précédentes, dans lequel le boîtier comprend un conducteur d'organe de polarisation (3), et une quatrième pluralité de fils de liaison (12) s'étendant de l'organe de polarisation au premier élément capacitif.

13. Boîtier d'amplificateur de puissance RF selon l'une quelconque des revendications précédentes, dans lequel la première fréquence de résonance se situe dans la plage de 5 à 20 MHz, la deuxième fréquence de résonance se situe dans la plage de 300 à 650 MHz, et la fréquence opérationnelle se situe dans la plage de 800 MHz à 3,5 GHz et plus, et/ou dans lequel la première puce à semi-conducteurs comprend une puce en silicium ou une puce en nitrure de gallium, et/ou dans lequel le transistor de puissance RF comprend au moins l'un parmi transistor métal-oxyde-semiconducteur à diffusion latérale et/ou un transistor à effet de champ.

14. Puce passive intégrée appropriée pour un boîtier d'amplificateur de puissance RF tel que défini selon l'une quelconque des revendications précédentes, dans lequel la puce passive intégrée comprend la deuxième puce telle que définie selon l'une quelconque des revendications précédentes.

15. Station de base de télécommunications mobiles comprenant le boîtier d'amplificateur de puissance RF tel que défini selon l'une quelconque des revendications 1 à 13.
